(19) Europäisches Patentamt
European Patent Office
Office européen des brevets

(11) Publication number: **0 115 668**
**B1**

(12) # EUROPEAN PATENT SPECIFICATION

(45) Date of publication of patent specification: **30.12.86**

(51) Int. Cl.[4]: **H 01 L 29/10,** H 01 L 27/08

(21) Application number: **83305659.1**

(22) Date of filing: **23.09.83**

(54) **Heterojunction semiconductor device.**

(30) Priority: **24.09.82 JP 166141/82**

(43) Date of publication of application:
**15.08.84 Bulletin 84/33**

(45) Publication of the grant of the patent:
**30.12.86 Bulletin 86/52**

(84) Designated Contracting States:
**DE FR GB**

(56) References cited:
**EP-A-0 056 904**
**EP-A-0 064 370**

**JAPANESE JOURNAL OF APPLIED PHYSICS, vol. 20, no. 8, August 1981, Tokyo T. MIMURA et al. "High electron mobility transistor logic"**

(73) Proprietor: **FUJITSU LIMITED**
**1015, Kamikodanaka Nakahara-ku**
**Kawasaki-shi Kanagawa 211 (JP)**

(72) Inventor: **Odani, Kouichiro c/o FUJITSU LIMITED**
**Patent Department 1015 Kamikodanaka**
**Nakahara-ku Kawasaki 211 (JP)**
Inventor: **Mimura, Takashi c/o FUJITSU LIMITED**
**Patent Department 1015 Kamikodanaka**
**Nakahara-ku Kawasaki 211 (JP)**

(74) Representative: **Sunderland, James Harry et al**
**HASELTINE LAKE & CO Hazlitt House 28**
**Southampton Buildings Chancery Lane**
**London WC2A 1AT (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 115 668 B1

## Description

This invention relates to a semiconductor device.

To further improve the capabilities of information processing systems etc., higher operational speed, lower power consumption and higher unit capacity are required of semiconductor devices which are employed for such systems.

At present, silicon (Si) semiconductor devices are predominantly utilised in such systems. However, since operational speed is rather limited for Si semi-conductor devices, due to factors determined by the physical properties of Si, e.g. the mobility of carriers therein, various efforts are being made to realize a higher operational speed and lower power consumption for semiconductor devices. One major effort is directed to the utilization of compound semiconductors, e.g. gallium-arsenide (GaAs), offering carrier mobilities far higher than Si.

Presently, most transistors which utilise compound semiconductors are field effect transistors (hereinafter referred to as FET's), particularly Schottky barrier gate FET's or junction gate FET's.

The structures of previous semiconductor devices allow carriers to pass through regions wherein impurities exist, so that operational speed is rather limited by various factors including the effects of ionized-impurity scattering.

It has been proposed to separate a space through which carriers pass from a space in which impurities exist, to increase the operational speed of a semiconductor device. This proposal has led to a new type semiconductor device the conductive channel of which consists of electrons accumulated to a two-dimensional surface contiguous with a heterojunction interleaved between a pair of semiconductor layers which have different electron affinities, due to the difference in electron affinities. This new type of semiconductor device, which utilizes the aforementioned accumulated electrons (hereinafter referred to as a two-dimensional electron gas), has been named a heterojunction semiconductor device, in accordance with the specific layer configuration.

Since the thickness of a two-dimensional electron gas is extremely small, specifically less than 100 angstroms, the two-dimensional electron gas has a geometrical position separated from either of the semiconductor layers constituting the heterojunction. As a result, the two-dimensional electron gas is free of the effects of ionized-impurity scattering, and thereby an extremely large electron mobility can be achieved particularly at a cryogenic temperature within the temperature range not exceeding 150°K.

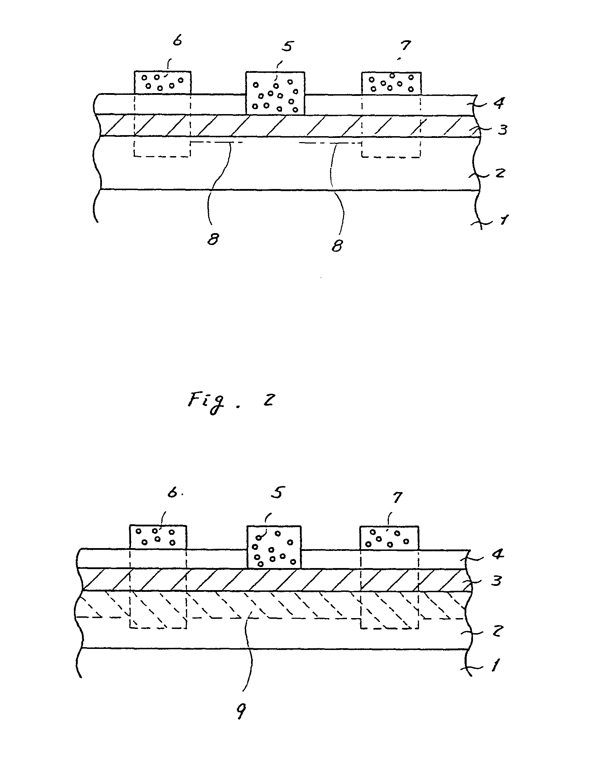

Referring to Figures 1 and 2, of the accompanying drawings, which are schematic sectional views, the layer configurations of two exemplary heterojunction field effect elements will be described below.

Referring to Figure 1, an undoped GaAs layer 2, an n-AlGaAs layer 3 and an n-GaAs layer 4 are grown in that order on a semi-insulating GaAs substrate 1. Heterojunctions are formed between GaAs layer 2 and AlGaAs layer 3 and between AlGaAs layer 3 and GaAs layer 4. A gate electrode 5 is produced on AlGaAs layer 3 or in a recess from which GaAs layer 4 is selectively removed to expose AlGaAs layer 3 at an appropriate location. Source and drain electrodes 6 and 7 are produced on GaAs layer 4.

Since the n-AlGaAs layer 3 is responsible for supplying electrons to a two-dimensional electron gas 8, the n-AlGaAs layer 3 is known as the electron source layer. Gate electrode 5 functions to regulate the surface electron density of the two-dimensional electron gas 8, as a result regulating the impedance between source electrode 6 and drain electrode 7. Thus, the heterojunction field effect element of which the layer configuration is shown in Figure 1 is allowed to function as an enhancement FET.

In the case of an enhancement FET as described above, the undoped GaAs layer 2 is approximately 1 µm thick, the n-AlGaAs layer 3 is approximately 40 nm thick and the n-GaAs layer 4 is approximately 30 nm thick, and these layers are grown in one step employing e.g. molecular beam epitaxy (hereinafter referred to as an MBE process). Impurities are introduced into the n-AlGaAs layer 3 and the n-GaAs layer 4 during the MBE process.

In relation to the device of Fig. 1, attention is directed to the Japanese Journal of Applied Physics, Vol 20, No. 8, August 198 , pages L598 to L600.

A depletion type element can be produced, as shown in Figure 2, by introducing n-impurities or donors into the upper part of undoped GaAs layer 2 or into the region in which the two-dimensional electron gas 8 would otherwise be accumulated, for the purpose of producing an n-type region 9. Attention is directed to Japanese Patent Application No. 57—29259, filed February 25, 1982, laid open to public inspection on September 1, 1983 under Publication No. 58—147078. In reality, however, this depletion type element does not necessarily function as a heterojunction field effect element. In other words, it rather resembles an insulated gate type FET. Since it does not necessarily exhibit the features inherent to a heterojunction field effect element as aforementioned, it can not strictly be identified as a heterojunction field effect element.

Further, provided an ion implantation process is employed for the inroduction of n-impurities into the whole region (including a source region and a drain region) at which a depletion type element is to be produced (assume an IC chip containing enhancement type elements and depletion type elements), as is the case when producing a GaAs Schottky barrier gate FET according to a prior proposal, problems as tabulated below are inevitable, because a heat treatment is required for activation of the n-impurities introduced by the ion implantation process.

(1) It is extremely difficult to activate an impurity e.g. silicon (Si) implanted to n-AlGaAs layer 3.

(2) Damage is easily produced in the neighbourhood of the heterojunction interleaved between GaAs layer 2 and n-AlGaAs layer 3.

(3) Provided the temperature of heat treatment is restricted to 700°C, to prevent the aforementioned heat damage from occurring, Si implanted into n-AlGaAs layer 3 is scarcely activated, and the activation rate of Si implanted into GaAs layers 2 and 4 is decreased to approximately 60%.

(4) Heat treatment causes damage not only in the neighbourhood of the heterojunction but also over the entire layer configuration, and this damage cannot be recovered by annealing.

It has been clarified above that a depletion type element produced by employing an ion implantation process has drawbacks including (1) a lesser electron mobility particularly in the layer in which a two-dimensional electron gas is expected to accumulate, (2) higher resistivity in the source region and drain region and also in the regions connecting the source region and a region facing a gate electrode and in the regions connecting the drain region and the region facing the gate electrode (3) higher power consumption.

EP—A—56 904 discloses a device having the features of the precharacterising part of claim 1.

According to the present invention there is provided a semiconductor device comprising a first semiconductor layer, and a second semiconductor layer of a semiconductor the electron affinity of which is larger than that of the semiconductor of the first semiconductor layer, the second semiconductor layer being arranged in contact with the first semiconductor layer to allow a two-dimensional electron gas to accumulate along the heterojunction between the first semiconductor layer and the second semiconductor layer, and further comprising a pair of electrodes ohmically connected to the two-dimensional electron gas, characterised in that the second semiconductor layer has an n-region arranged in contact with the two-dimensional electron gas such that a conductive channel between the electrodes of the pair is defined by the two-dimensional electron gas and the n-region, to provide a depletion type heterojunction element.

In an embodiment of the present invention having a gate electrode on the first semiconductor layer, the zone is such that an upper surface thereof is limited to the extent of a bottom surface of the gate electrode, which it confronts.

An embodiment of the present invention provides a depletion type element which falls into the category of heterojunction field effect elements. The element can afford (1) increased electron mobility, (2) decreased resistivity in the source region and the drain region, and also in the regions connecting the source region and a region facing a gate electrode and in the regions connecting the drain region and the region facing the gate electrode, as a result decreasing the contact resistance of the source and drain, (3) decreased power consumption, (4) improved reproductivity and (5) improved overall reliability.

The semiconductor of the first semiconductor layer may be AlGaAs, and the semiconductor of the second semiconductor layer may be GaAs.

Reference is made, by way of example, to the accompanying drawings, in which:—

Figure 1 is a schematic cross-sectional view of a previously proposed enhancement type heterojunction field effect element.

Figure 2 is a schematic cross-sectional view of a previously proposed depletion type element.

Figure 3 is a schematic cross-sectional view of a wafer wherein a semiconductor device consisting of an enhancement type heterojunction field effect element and a depletion type heterojunction field effect element in accordance with an embodiment of the present invention are scheduled to be produced, after completion of an ion implantation process for producing an n-region which is to function as the conductive channel of the aforementioned depletion element.

Figure 4 is a schematic cross-sectional view of the wafer of Figure 3, after completion of the n-region which is to function as the conductive channel of the aforementioned depletion element.

Figure 5 is a schematic cross-sectional view of the wafer of Figures 3 and 4, after completion of isolation regions.

Figure 6 is a schematic cross-sectional view of a semiconductor device consisting of an enhancement type heterojunction field effect element and a depletion type heterojunction field effect element in accordance with an embodiment of the present invention.

Figure 7 is an energy band diagram of a depletion type heterojunction field effect element in accordance with an embodiment of the present invention, and

Figure 8 is a schematic cross-sectional view of a semiconductor device consisting of an enhancement type heterojunction field effect element and a depletion load resistor element in accordance with an embodiment of the present invention.

In the following description, an embodiment of the present invention wherein an enhancement type heterojunction field effect element and a depletion type heterojunction field effect element are produced on one semiconductor substrate, will be presented.

Referring to Figure 3, an MBE process is employed to grow an undoped GaAs layer 12 having an approximate thickness of 1 µm, an n-AlGaAs layer 13 doped to an approximate concentration of $1\times10^{18}/cm^3$ and having an approximate thickness of 40 nm, and an n-GaAs layer 14 having an approximate thickness of 30 nm, in that order, on a semi-insulating GaAs substrate 11.

A protection film 15 of e.g. aluminium nitride (AlN) having an approximate thickness is produced on the top surface of n-GaAs layer 14 employing e.g. sputtering.

Photoresist (AZ 1350J) is spin-coated on the top surface of the protection film 15 to produce a photoresist film 16, which photoresist is covered by a Ti film 17 which is further covered by an Au film 18. The stacked layers 18, 17 and 16 are selectively removed from a location on which a gate electrode is scheduled to be produced. In reality, however, the area from which the layers 18, 17 and 16 are removed is slightly larger than that of the gate electrode by a margin for mask positioning. The remaining parts of the layers 18, 17 and 16 function as a mask for an ion implantation process by which an n-impurity is introduced into a location where a highly n-doped region, which is to function as the conductive channel of the depletion type element, is scheduled to be produced. The mask consists not only of a photoresist film 16 but also of two metal films 17 and 18 to enhance the protection afforded for the interfaces between n-GaAs layer 14, n-AlGaAs layer 13 and undoped GaAs layer 12, particularly between n-AlGaAs layer 13 and undoped GaAs layer 12 at which a two-dimensional electron gas is accumulated.

Employing this mask, Si is implanted at a speed (rate) of e.g. 170 KeV to $2\times10^{12}/cm^2$ into a region indicated by 19 in Figure 3.

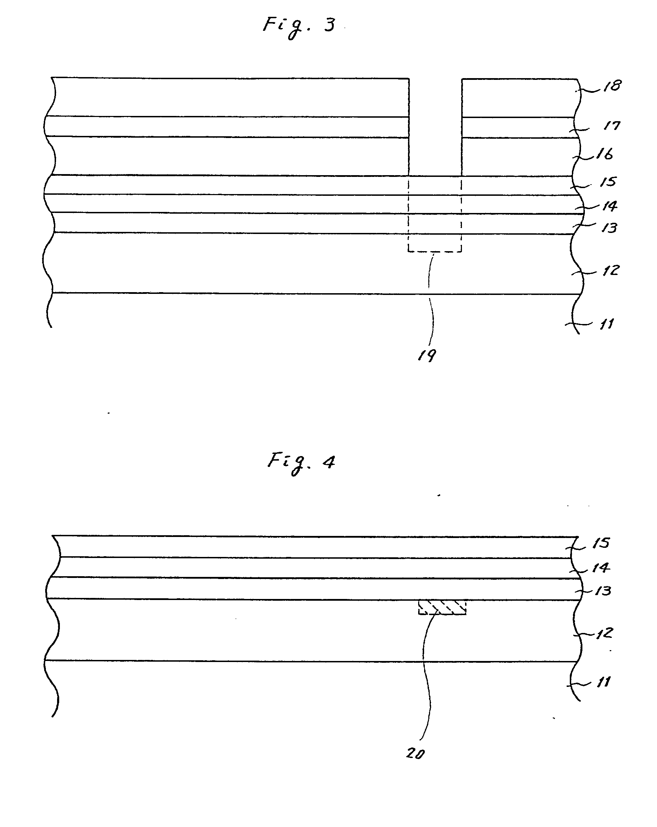

Referring to Figure 4, a so-called lift-off process is employed to remove the mask consisting of Au-film 18, Ti-film 17 and photoresist film 16.

A heat treatment process is then applied to the wafer which has suffered the aforementioned steps, at a temperature of e.g. 700°C for approximately 20 minutes, to activate the implented Si. In this manner, an n-region 20 having an approximate impurity concentration of $1\times10^{17}/cm^3$ and which is scheduled to act as the conductive channel of the depletion element is produced in a very limited space which is in undoped GaAs layer 12 along the heterojunction between n-AlGaAs layer 13 and undoped GaAs layer 12 and which precisely faces the location at which a gate electrode is scheduled to be produced on n-AlGaAs layer 13 in a later step. Due to the difficulty of activating Si-S implanted in AlGaAs, the conductivity of n-AlGaAs layer 13 remains unchanged.

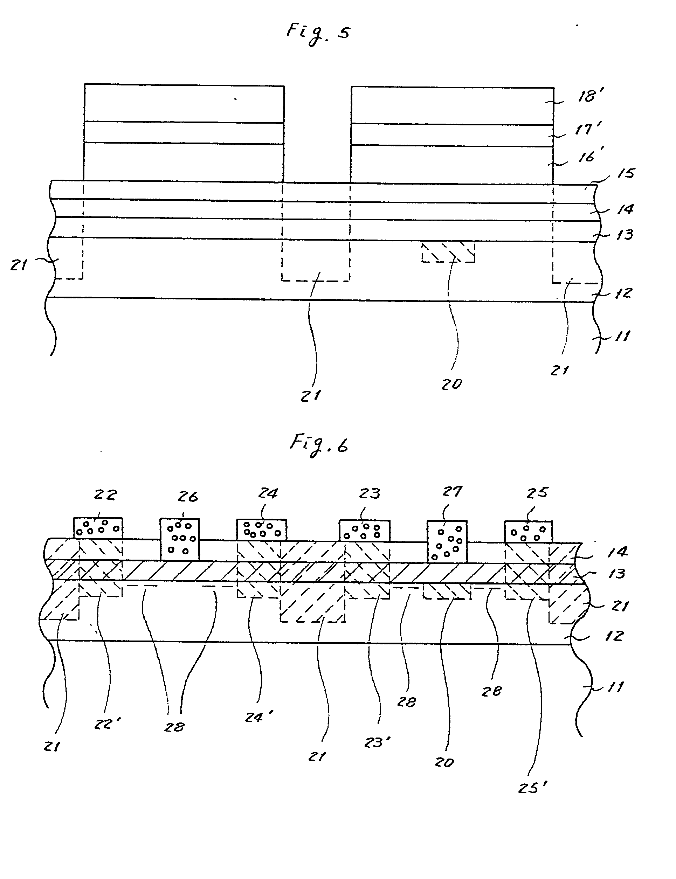

Referring to Figure 5, photoresist (AZ 1350J) is spin-coated on the top surface of the protection film 15 to produce a photoresist film 16′ which is covered by a Ti film 17′ which is further covered by an Au film 18′. These stacked layers 18′, 17′ and 16′ are selectively removed from the top surfaces of areas under which isolation regions 21 are scheduled to be produced. Employing the remaining parts of the layers 18′, 17′ and 16′ as a mask, oxygen (O) ions are implanted at a speed (rate) of 100 KeV, which is enough to cause the O ions to reach undoped GaAs layer 12, penetrating n-AlGaAs layer 13, to $2\times10^{12}/cm^2$ in regions where isolation regions 21 are scheduled to be produced. After the ion implantation, an annealing process is applied to the wafer. Thus, isolation regions 21 having resistance and which surround each element, are produced.

Referring to Figure 6, the mask consisting of the layers 18′, 17′ and 16′ and the protection film 15 are removed, before source electrodes 22 and 23 and drain electrodes 24 and 25 consisting of Au · Ge/Au layers are produced. A heat treatment process which is carried out at 450°C for approximately 3 minutes causes Au · Ge to alloy with the compound semiconductors 14, 13 and 12, producing source regions 22′ and 23′ and drain regions 24′ and 25′.

Parts of the n-GaAs layer 14 are removed selectively from locations at which gate electrodes are scheduled to be produced. This step can be carried out by employing a gas etching process using $CCl_2F_2$. At the locations from which parts of n-GaAs layer 14 have been selectively removed, gate electrodes 26 and 27 consisting of e.g. Ti/Pt/au are produced. The center of the bottom surface of the gate electrode 27 precisely corresponds to the center of the n-region 20.

The above description has made it clear that the aforementioned steps produce an integrated circuit consisting of an enhancement type heterojunction field effect element and a depletion type heterojunction field effect element.

The former (the enhancement type element) consists of undoped GaAs layer 12 produced on semi-insulating GaAs substrate 11, n-AlGaAs layer 13, n-GaAs layer 14 (of which part is removed from the location at which the gate electrode is produced), the source electrode 22 produced on the top surface of n-GaAs layer 14 and which is accompanied by the source region 22′, the drain electrode 24 produced on the top surface of n-GaAs layer 14 and which is accompanied by the drain region 24′, the gate electrode 26 produced on the top surface of n-AlGaAs layer 13, and isolation regions 21 which further comprise regions of high resistance, such regions surrounding each element. The thickness and impurity concentration of each layer are selected to allow a two-dimensional electron gas 28 to accumulate along the heterojunction between n-AlGaAs layer 13 and undoped GaAs layer 12 and to function in an enhancement mode.

The latter (the depletion type element) consists of undoped GaAs layer 12 produced on semi-insulating GaAs substrate 11 and which is provided with the n-region 20 produced in a limited region of which the upper surface faces the bottom surface of the gate electrode 27, n-AlGaAs layer 13, n-GaAs layer 14 (of which part is removed from the location at which the gate electrode is produced), the source electrode 23 produced on the top surface of n-GaAs layer 14 and which is accompanied by the source region 23′, the drain electrode 25 produced on the top surface of n-GaAs layer 14 and which is accompanied by the drain region 25′, the gate electrode 27 produced on the top surface of n-AlGaAs layer 13, and isolation regions 21 which further comprise regions of high resistance, such regions surrounding each element.

The thickness and impurity concentration of each layer are in principle identical to those of the former (the enhancement type element), except for the n-region 20 which is produced in a very limited region of which the upper surface faces the bottom surface of the gate electrode 27. Therefore, the surface electron density of the two-dimensional electron gas 28 which is allowed to accumulate along the heterojunction between n-AlGaAs layer 13 and undoped GaAs layer 12 for this depletion type element is identical to that of the corresponding (Figure of the aforementioned) enhancement type element, (in) the location contiguous with the n-region 20. This is extremely important to reduce the contact resistance of the source and drain.

In addition, since no ions are implanted into source regions 22′ and 23′ and drain regions 24′ and 25′, no damage is produced in these regions. This is also important to reduce the contact resistance of the source and drain.

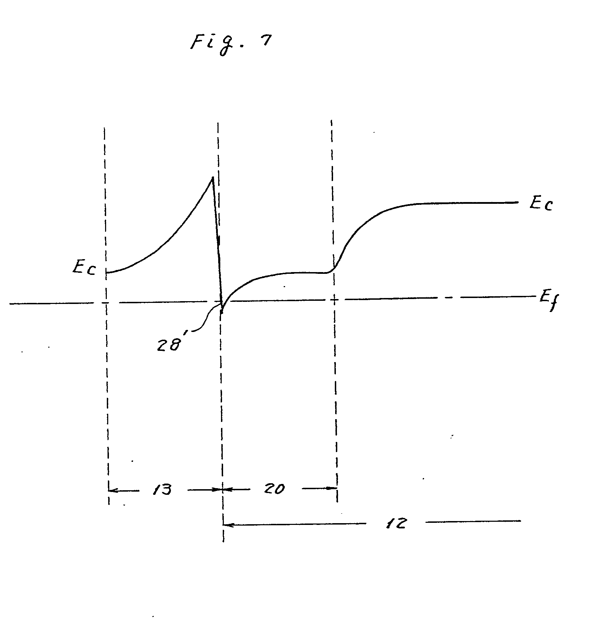

Further, as shown in the energy band diagram of Figure 7, a two-dimensional electron gas 28′ is allowed to accumulate along the heterojunction between n-AlGaAs layer 13 and the n-region 20 which is located in undoped GaAs layer 12, albeit the surface electron density is rather limited depending on the degree of damage suffered at this location. In any case, however, the conductive channel of this depletion type element consists of both the two-dimensional electron gas 28′ and electrons activated in the n-region 20. As a result, the operational speed of this depletion type element is improved and brought up to a level similar to that of the enhancement type element.

From the above description it will be clear that a depletion type element, which is a heterojunction field effect element, is provided by an embodiment of the present invention wherein (1) electron mobility is increased, (2) resistivity is decreased in the source region and the drain region and also in the regions connecting the source region and the region facing a gate electrode and in the regions connecting the drain region and the region facing the gate electrode, as a result decreasing the contact resistance of the source and drain, (3) power consumption is decreased, (4) reproductivity is improved, and (5) overall reliability is improved.

An enhancement-depletion mode inverter can be constructed using an enhancement type element and the depletion type element as shown in Figure 6 and the inverter will be suitable for high speed operation.

Although the depletion type element of Figure 6 is provided with the gate electrode 27, a load element for an inverter circuit may not necessitate the provision of such a gate electrode.

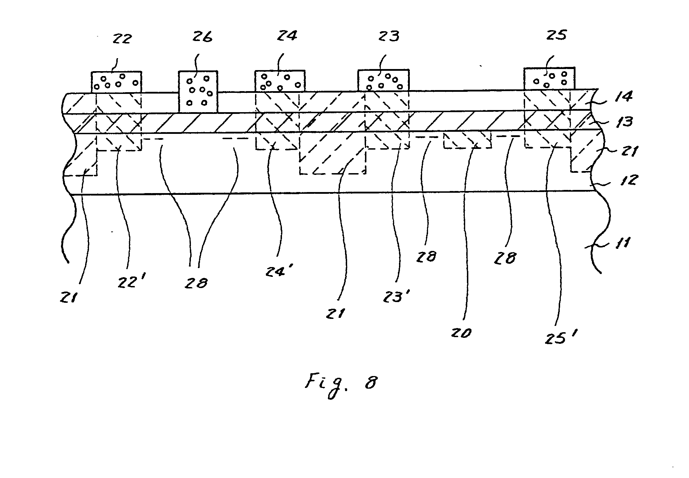

Figure 8 is a cross sectional of such an inverter circuit. It will be noted that the recess etching is not carried out (parts of n-GaAs layer 14 are not removed) in the load element and the electron source layer 13 is capped by layer 14. Since a gate electrode is not placed between the terminals of the load element, the inverter circuit as shown in Figure 8 is suitable for higher integration.

**Claims**

1. A semiconductor device comprising a first semiconductor layer (13), and a second semiconductor layer (12) of a semiconductor the electron affinity of which is larger than that of the semiconductor of the first semiconductor layer (13), the second semiconductor layer (12) being arranged in contact with the first semiconductor layer (13) to allow a two-dimensional electron gas (28) to accumulate along the heterojunction between the first semiconductor layer (13) and the second semiconductor layer (12), and further comprising a pair of electrodes (23, 25) ohmically connected to the two-dimensional electron gas (28), characterised in that the second semiconductor layer (12) has an n-region (20) arranged in contact with the two-dimensional electron gas (28) such that a conductive channel between the electrodes (23, 25) of the pair is defined by the two-dimensional electron gas (28) and the n-region (20), to provide a depletion type heterojunction element.

2. A device as claimed in claim 1, wherein the electrodes (23, 25) of the said pair are respectively a source and a drain electrode, the device further comprising a gate electrode (27) arranged between the source and drain electrodes (23, 25), the n-region (20) having an upper surface which confronts a bottom surface of the gate electrode (27).

3. A device as claimed in claim 1, wherein the depletion type heterojunction element is a load element.

4. A semiconductor device as claimed in claim 1, 2 or 3, further including:

an enhancement type element, comprising two semiconductor layers (12, 13), the semiconductor of one (12) of those layers having an electron affinity larger than that of the semiconductor of the other (13) of those layers, and said one layer (12) being arranged in contact with the said other layer (13) to allow a two-dimensional electron gas (28) to accumulate along the heterojunction between those layers, the enhancement type element further comprising a gate electrode (26) arranged on the said other layer (13), and source and drain electrodes (22, 24) arranged on opposite sides of the gate electrode (26); and

isolation regions (21) surrounding the enhancement type element and the depletion type element.

5. A device as claimed in any preceding claim, wherein the semiconductor layers (12, 13) are formed by molecular beam epitaxy.

6. A device as claimed in any preceding claim, wherein the n-region (20) is formed by ion implantation.

**Patentansprüche**

1. Halbleitervorrichtung mit einer ersten Halbleiterschicht (13), und einer zweiten Halbleiterschicht (12) aus einem Halbleiter, dessen Elektronenaffinität größer als diejenige des Halbleiters der ersten Halbleiterschicht (13) ist, wobei die zweite Halbleiterschicht (12) in Kontakt mit der ersten Halbleiterschicht (13) angeordnet ist, um zu erlauben, daß ein zweidimensionales Elektronengas (28) sich längs dem Heteroübergang zwischen der ersten Halbleiterschicht (13) und der zweiten Halbleiterschicht (12) ansammelt, und ferner mit einem Paar von Elektroden (23, 25), die obmisch mit dem zweidimensionalen Elektronengas (28) verbunden sind, dadurch gekennzeichnet, daß die zweite Halbleiterschicht (12) einen n-Bereich (20) hat, der in Kontakt mit dem zweidimensionalen Elektronengas (28) so angeordnet ist, daß ein leitender Kanal zwischen den Elektroden (23, 25) des Paares durch des zweidimensionale Elektronengas (28) und den n-Bereich (20) definiert ist, um ein Heteroübergangselement vom Verarmungstyp zu bilden.

2. Vorrichtung nach Anspruch 1, bei welcher die Elektroden (23, 25) des genannten Paares jeweils eine Source- bzw. eine Drainelektrode sind, die Vorrichtung ferner eine Gateelektrode (27) umfaßt, die zwischen den Source- und Drainelektroden (23, 25) angeordnet ist, und der n-Bereich eine obere Oberfläche hat, welche einer unteren Oberfläche der Gateelektrode (27) konfrontiert ist.

3. Vorrichtung nach Anspruch 1, bei welcher das Heteroübergangselement vom Verarmungstyp ein Lastelement ist.

4. Halbleitervorrichtung nach Anspruch 1, 2 oder 3, ferner mit:

einem Element vom Aureicherungstyp, welches zwei Halbleiterschichten (12, 13) umfaßt, wobei der Halbleiter von einer (12) jener Schichten eine Elektronenaffinität hat, die größer als diejenige des Halbleiters der anderen (13) jener Schichten ist, die genannte eine Schicht (12) in Kontakt mit der genannten anderen Schicht (13) gebildet ist, um zu erlauben, daß ein zweidimensionales Elektronengas (28) sich längs des Heteroübergangs zwischen jenen Schichten bildet, das Element vom Anreicherungstyp ferner eine Gateelektrode (26) umfaßt, die auf der genannten einen Schicht (13) angeordnet ist, und Source- und Drainelektroden (22, 24) an gegenüberliegenden Seiten der Gateelektrode (26) angeordnet sind; und

Isolationsbereichen (21), die das Element vom Anreicherungstyp und das Element vom Verarmungstyp umgeben.

5. Vorrichtung nach einem der vorhergehenden Ansprüche, bei welcher die Halbleiterschichten (12, 13) durch Molekularstrahlepitaxie gebildet sind.

6. Vorrichtung nach einem der vorhergehenden Ansprüche, bei welcher der n-Bereich (20) durch Ionenimplantation gebildet ist.

**Revendications**

1. Dispositif semiconducteur comprenant une première couche semiconductrice (13), et une deuxième couche semiconductrice (12) d'un semiconducteur dont l'affinité électronique est plus grande que celle du semiconducteur de la première couche semiconductrice (13), la deuxième couche semiconductrice (12) étant disposée en contact avec la première couche semiconductrice (13) afin de permettre qu'un gaz électronique bidimensionnel (28) s'accumule le long de l'hétérojonction existant entre la première couche semiconductrice (13) et la deuxième couche semiconductrice (12), et comprenant en outre une paire d'électrodes (23, 25) ohmiquement connectées au gaz électronique bidimensionnel (28), caractérisé en ce que la deuxième couche semiconductrice (12) possède une région n (20) disposée en contact avec le gaz électronique bidimensionnel (28) de façon qu'un canal conducteur entre les électrodes (23, 25) de la paire soit défini par le gaz électronique bidimensionnel (28) et la région n (20), afin de produire un élément à hétérojonction du type appauvrissement.

2. Dispositif selon la revendication 1, où les électrodes (23, 25) de ladite paire sont respectivement une électrode de source et une électrode de drain, le dispositif comprenant en outre une électrode de grille (27) disposée entre les électrodes de source et de drain (23, 25), la région n (20) possédant une surface supérieure qui est en regard d'une surface inférieure de l'électrode de grille (27).

3. Dispositif selon la revendication 1, où l'élément à hétérojonction du type appauvrissement est un élément de charge.

4. Dispositif semiconducteur selon la revendication 1, 2 ou 3, comportant en outre:

un élément du type enrichissement, comprenant deux couches semiconductrices (12, 13), le semiconducteur de l'une (12) de ces couches possédant une affinité électronique plus grande que celle du semiconducteur de l'autre (13) de ces couches, ladite couche (12) première citée étant disposée en contact avec ladite autre couche (13) afin de permettre qu'un gaz électronique bidimensionnel (28) s'accumule le long de l'hétérojonction existant entre ces couches, l'élément du type enrichissement comprenant en outre une électrode de grille (26) disposée sur ladite autre couche (13), et des électrodes de source et de drain (22, 24) disposées de part et d'autre de l'électrode de grille (26); et

des régions d'isolation (21) entourant l'élément du type enrichissement et l'élément du type appauvrissement.

5. Dispositif selon l'une quelconque des revendications précédentes, où les couches semiconductrices (12, 13) sont formées par épitaxie de faisceau moléculaire.

6. Dispositif selon l'une quelconque des revendications précédentes, où la région n (20) est formée par implantation ionique.

6
5
7
4
3
2
1
8
8

Fig. 2

6
5
7
4
3
2
1
9

Fig. 3
18
17
16
15
14
13
12
11
19

Fig. 4
15
14
13
12
11
20

Fig. 5

18'
17'
16'
15
14
13
21
12
11
21
20
21

Fig. 6

22
26
24
23
27
25
14
13
21
12
11
21
22'
28
24'
21
23'
28
20
28
25'

Fig. 7

Ec
Ec
Ef
28'
13
20
12

22
26
24
23
25
14
13
21
12
11
21
22'
28
24'
21
23'
28
20
28
25'

Fig. 8